# EUROPÄISCHE PATENTSCHRIFT

(11) **EP 2 255 396 B1**
(45) Veröffentlichungstag und Bekanntmachung des Hinweises auf die Patenterteilung: **29.08.2018**
(21) Anmeldenummer: 09712047.1
(22) Anmeldetag: 19.02.2009
(51) Int. Cl.: H01L 33/52

(54) **VERFAHREN ZUR HERSTELLUNG EINER MEHRZAHL VON STRAHLUNGSEMITTIERENDEN BAUELEMENTEN**
METHOD FOR PRODUCING A PLURALITY OF RADIATION EMITTING COMPONENTS
PROCÉDÉ DE FABRICATION D'UNE PLURALITÉ DE COMPOSANTS ÉMETTEURS DE RAYONNEMENT

(30) Priorität: 22.02.2008 DE 102008010510; 19.03.2008 DE 102008014927
(43) Veröffentlichungstag der Anmeldung: 01.12.2010
(73) Patentinhaber: OSRAM Opto Semiconductors GmbH, 93055 Regensburg (DE)
(72) Erfinder: PREUSS, Stephan, 32832 Augustdorf (DE); JÄGER, Harald, 93049 Regensburg (DE)
(74) Vertreter: Epping - Hermann - Fischer
(86) Internationale Anmeldenummer: PCT/DE2009/000249
(87) Internationale Veröffentlichungsnummer: WO 2009/103283

(56) Entgegenhaltungen:
- EP-A- 1 753 035
- EP-A- 1 806 782
- WO-A-2006/054616
- JP-A- 10 229 097
- JP-A- 11 074 410
- US-A1- 2002 185 966
- US-A1- 2006 030 125
- US-B1- 6 345 903
- US-B1- 6 743 699

## Beschreibung

Es wird ein Verfahren zur Herstellung einer Mehrzahl von strahlungsemittierenden Bauelementen angegeben.

Die Druckschrift WO 2006/054616 A1 ist auf ein Verfahren zur Herstellung von LEDs gerichtet, bei dem LED-Chips auf Trägern angebracht und mit einem Umhüllungsmaterial vergossen werden. In der Druckschrift US 2002/0185966 A1 findet sich ein Herstellungsverfahren für LEDs, bei dem eine zusammenhängende transparente Vergussschicht auf eine Mehrzahl von LED-Chips aufgebracht wird, die auf einer Trägerschicht angeordnet sind. Trägerschicht und Vergussschicht werden jeweils in nachfolgenden separaten Fertigungsschritten durchtrennt. Aus der Druckschrift EP 1 753 035 A1 ist ein Herstellungsverfahren für LEDs bekannt, bei dem LED-Chips mit einem insbesondere linsenförmigen Vergusskörper versehen werden.

Eine Aufgabe ist es, ein Verfahren zur Herstellung einer Mehrzahl von strahlungsemittierenden Bauelementen anzugeben. Diese Aufgabe wird durch das Verfahren des Patentanspruchs 1 gelöst. Vorteilhafte Ausführungsformen und Weiterbildungen des Verfahrens sind in den abhängigen Ansprüchen gekennzeichnet und gehen weiterhin aus der nachfolgenden Beschreibung hervor.

Das erfindungsgemäße Verfahren zur Herstellung einer Mehrzahl von strahlungsemittierenden Bauelementen umfasst die Verfahrensschritte:
A) Bereitstellen einer Trägerschicht mit einer Mehrzahl von Montagebereichen, wobei die Montagebereiche durch Trennbereiche voneinander getrennt sind,
B) Aufbringen einer Zwischenschicht auf die Trennbereiche,
C) Aufbringen jeweils einer strahlungsemittierenden Vorrichtung auf jeden der Mehrzahl der Montagebereiche,
D) Aufbringen einer zusammenhängenden Vergussschicht auf die strahlungsemittierenden Vorrichtungen und die Trennbereiche,
E) Durchtrennen der Vergussschicht und partielles Durchtrennen der Zwischenschicht in den Trennbereichen der Trägerschicht in einem ersten Trennschritt,
F) Partielles Durchtrennen der Zwischenschicht und Durchtrennen der Trägerschicht in einem zweiten Trennschritt, wobei die Zwischenschicht durch den ersten und den zweiten Trennschritt vollständig durchtrennt wird.

Dass eine erste Schicht, ein erster Bereich oder eine erste Vorrichtung "auf" einer zweiten Schicht, einem zweiten Bereich oder einer zweiten Vorrichtung angeordnet oder aufgebracht ist, kann dabei hier und im Folgenden bedeuten, dass die erste Schicht, der erste Bereich oder die erste Vorrichtung unmittelbar in direktem mechanischen und/oder elektrischen Kontakt auf der zweiten Schicht, dem zweiten Bereich oder der zweiten Vorrichtung beziehungsweise zu den zwei weiteren Schichten, Bereichen oder Vorrichtungen angeordnet oder aufgebracht ist. Weiterhin kann auch ein mittelbarer Kontakt bezeichnet sein, bei dem weitere Schichten, Bereiche und/oder Vorrichtungen zwischen der ersten Schicht, dem ersten Bereich oder der ersten Vorrichtung und der zweiten Schicht, dem zweiten Bereich oder der zweiten Vorrichtung beziehungsweise den zwei weiteren Schichten, Bereichen oder Vorrichtungen angeordnet sind.

"Trennen", "Durchtrennen" oder "Trennung" bedeuten hier und im Folgenden eine Formveränderung einer Schicht oder eines Bereiches, in dem der Zusammenhalt örtlich aufgehoben wird. Bei einem Trennen, einem Durchtrennen oder einer Trennung werden zur Formänderung Teile einer Schicht oder eines Bereiches abgetrennt. Dabei kann das Trennen, Durchtrennen oder die Trennung nicht-mechanisch oder mechanisch, wie beispielsweise durch ein Zerteilen, ein Spanen oder ein Abtragen erfolgen und zur Formveränderung einer Schicht oder eines Bereiches mit zum Zerteilen, Spanen oder Abtragen geeigneten Trennwerkzeugen bedeuten.

Die im Rahmen des hier beschriebenen Verfahrens herstellbaren strahlungsemittierenden Bauelemente können im Vergleich mit bekannten Herstellungsmethoden von strahlungsemittierenden Bauelementen eine verbesserte Trennbarkeit der einzelnen strahlungsemittierenden Bauelemente voneinander aufweisen. Dabei kann die Trennbarkeit von zumindest zwei strahlungsemittierenden Bauelementen qualitativ dadurch verbessert werden, dass eine Zwischenschicht im Trennbereich zwischen zwei strahlungsemittierenden Bauelementen auf der Trägerschicht angeordnet wird.

Jeder der Trennbereiche ist getrennt von und/oder benachbart zu dazwischen liegenden Montagebereichen angeordnet, die jeweils die strahlungsemittierenden Vorrichtungen der strahlungsemittierenden Bauelemente aufweisen. Die auf den strahlungsemittierenden Vorrichtungen aufgebrachte Vergussschicht kann sich aufgrund der Materialzusammensetzung in ihren physikalischen Eigenschaften, wie beispielsweise Härte, Steifigkeit, Festigkeit, Duktivität, Risszähigkeit oder Dichte, von der Trägerschicht unterscheiden, sodass es erforderlich ist, die zumindest zwei strahlungsemittierenden Bauelemente mit zwei Trennschritten und zwei verschiedenen Trennwerkzeugen voneinander zu trennen.

In einem herkömmlichen Verfahren kann ein direkter Übergang von der Vergussschicht zur Trägerschicht bei beispielsweise unterschiedlichen Härten dieser Schichten dazu führen, dass das zur Trennung der Vergussschicht geeignete Trennwerkzeug beim Auftreffen auf die Trägerschicht beschädigt und funktionslos wird. Der Funktionsverlust des Trennwerkzeugs kann verhindert werden, indem im Trennbereich zwischen zwei strahlungsemittierenden Bauelementen die Zwischenschicht zwischen der Trägerschicht und der Vergussschicht angeordnet wird, die von sowohl von einem Trennwerkzeug, das für die Trennung der Trägerschicht, als auch von einem Trennwerkzeug, das für die Trennung der Vergussschicht geeignet ist, durchtrennt werden kann und somit als Puffer- oder Schutzschicht dient.

In einer Ausführungsform kann die Trennung im ersten Trennschritt und im zweiten Trennschritt jeweils mit einer Säge durchgeführt werden. Dies kann bedeuten, dass die Verfahrensschritte E) und F) vollständig mit einer Säge als einzigem Trennwerkzeug durchgeführt werden können.

Weiterhin kann die Säge als Beispiel für ein spanendes Trennwerkzeug verwendet werden, um die Trägerschicht, die Zwischenschicht und die Vergussschicht mit ihren physikalisch unterschiedlichen Eigenschaften zu trennen. Die Verwendung einer Säge als mechanisches Trennwerkzeug ermöglicht zum anderen eine kostengünstige Herstellung von einer Mehrzahl strahlungsemittierender Bauelemente in einer Hochvolumenfertigung.

Weiterhin kann die Trennung gemäß dem ersten Trennschritt mit einem ersten Sägeblatt durchgeführt werden. Bei diesem ersten Trennschritt kann zur vollständigen Trennung der Vergussschicht und der partiellen Durchtrennung der Zwischenschicht in den Trennbereichen der Trägerschicht gemäß dem Verfahrensschritt E) ein erstes Sägeblatt verwendet werden, das sowohl die Vergussschicht als auch die Zwischenschicht durchtrennen kann. Dabei ist das erste Sägeblatt besonders für das Durchtrennen der Vergussschicht geeignet, wobei die Vergussschicht während des ersten Trennschrittes vollständig durchtrennt wird.

In einem herkömmlichen Verfahren kann die Vergussschicht während des ersten Trennschrittes mit einem Sägeblatt nicht vollständig durchtrennt werden, da ein geringer Teil der Vergussschicht als Schutzschicht erhalten bleiben muss, um das Auftreffen des Sägeblatts auf die Trägerschicht und eine damit verbundene Beschädigung des Sägeblatts zu verhindern. Dabei erweist sich aber der geringe Teil der verbleibenden Vergussschicht als nachteilig für den zweiten Trennschritt, da sich Reste der Vergussschicht an der Trennkante anlagern können und sich bei der weiteren Verarbeitung des strahlungsemittierenden Bauelements lösen können. Dies führt bei bekannten Herstellungsverfahren zu einer Verschmutzung der strahlungsemittierenden Bauelemente, was die Reinigung der strahlungsemittierenden Bauelemente in einem zusätzlichen Reinigungsschritt erfordert.

Zusätzlich können sich die Reste der Vergussschicht während des zweiten Sägeschrittes bei bekannten Verfahren auch am Sägeblatt anlagern, was zu einer Verschlechterung des Sägeergebnisses aufgrund fortschreitender Abstumpfung des Sägeblattes führt. Das Sägeblatt kann Diamantkörner aufweisen, die in eine Kunststoffmatrix, in eine Metallmatrix oder alternativ auch in eine Keramikmatrix eingebettet sind und zu Beginn des Sägens noch über eine ausreichende Schärfe verfügen. Während des Sägens können abgestumpfte Diamantkörner aus der Kunststoffmatrix herausbrechen und damit neue, scharfe Diamantkörner freilegen. Durch die Anlagerung der Reste der Vergussschicht an die neuen, scharfen Diamantkörner bei bekannten Herstellungsverfahren kann das Sägeblatt fortschreitend abstumpfen.

Durch die erfindungsgemäße Anordnung der Zwischenschicht zwischen die Vergussschicht und die Trägerschicht kann eine vollständige Abtrennung der Vergussschicht ermöglicht werden, wodurch Rückstände der Vergussschicht auf dem zweiten Sägeblatt weitgehend ausbleiben und ein verbessertes Trennergebnis erzielt werden kann.

Der zweite Trennschritt kann gemäß einer weiteren Ausführungsform mit einem zweiten Sägeblatt durchgeführt werden, das verschieden vom ersten Sägeblatt ist. Dabei durchtrennt das zweite Sägeblatt die Zwischenschicht ebenfalls partiell und durchtrennt die Trägerschicht vollständig. Das bedeutet, dass sowohl das erste Sägeblatt, als auch das zweite Sägeblatt die Zwischenschicht durchtrennen können, ohne dass beispielsweise das erste Sägeblatt durch ein Auftreffen auf die Trägerschicht beschädigt wird.

Weiterhin können das erste und das zweite Sägeblatt eine gleiche Dicke aufweisen. Dabei können das erste und das zweite Sägeblatt jeweils eine Dicke von 50 µm bis 350 µm aufweisen. Durch die einheitliche Dicke des ersten und des zweiten Sägeblatts können Unebenheiten in den Trennbereichen nach dem ersten oder zweiten Trennschritt zumindest weitgehend oder auch ganz vermieden werden.

Weiterhin kann vor dem Verfahrensschritt C) in der Mehrzahl der Montagebereiche der Trägerschicht jeweils zumindest eine elektrische Kontaktschicht aufgebracht werden. Dabei dient die zumindest eine elektrische Kontaktschicht der elektrischen Kontaktierung der strahlungsemittierenden Vorrichtung von Seiten der Trägerschicht her und kann beispielsweise als Leiterbahn auf der Trägerschicht ausgeformt sein. Die strahlungsemittierenden Vorrichtungen können dazu beispielsweise jeweils eine der Trägerschicht zugewandte Elektrode aufweisen, mit der die strahlungsemittierenden Vorrichtungen jeweils in den Montagebereichen auf die zumindest eine elektrische Kontaktschicht aufgebracht werden können. Zur Gegenkontaktierung können die strahlungsemittierenden Vorrichtungen beispielsweise mit einer der Trägerschicht abgewandten Elektrode versehen sein, die etwa über einen Bonddraht an eine der zumindest einen elektrischen Kontaktschicht elektrisch angeschlossen werden kann. Alternativ dazu können die strahlungsemittierenden Vorrichtungen mittels der bekannten so genannten Flip-Chip-Kontaktierung auf jeweils zumindest zwei elektrischen Leiterbahnen in den Montagebereichen elektrisch angeschlossen werden.

Weiterhin kann die zumindest eine elektrische Kontaktschicht ein gleiches Material aufweisen oder aus dem gleichen Material sein wie die Zwischenschicht. Dadurch, dass die Zwischenschicht das gleiche Material umfassen kann wie die zumindest eine elektrische Kontaktschicht, beispielsweise Kupfer, Nickel, Silber, Wolfram, Molybdän oder Gold oder Legierungen oder Mischungen mit den beschriebenen Metallen in einem veränderlichen prozentualen Verhältnis oder eine Schichtenfolge mit den genannten Materialien, können die zumindest eine elektrische Kontaktschicht und die Zwischenschicht gleichzeitig im Verfahrensschritt B) aufgebracht werden.

Weiterhin kann die Trägerschicht eine erste Härte, die Zwischenschicht eine zweite Härte und die Vergussschicht eine dritte Härte aufweisen, wobei die erste Härte größer sein kann als die zweite Härte und die zweite Härte größer sein kann als die dritte Härte. Demnach kann die Vergussschicht eine gegenüber der Zwischenschicht geringere Härte aufweisen, wobei die Zwischenschicht wiederum eine geringere Härte aufweisen kann als die Trägerschicht.

Dabei können sich die Materialien, die für die Trägerschicht verwendet werden und beispielsweise ein Keramik-Material, ein Halbleitermaterial wie beispielsweise Silizium oder Metalle, die weiterhin auch auf der Oberfläche oxidiert sein können, oder einen Kunststoff umfassen, durch eine große Härte auszeichnen. Dabei kann das Keramik-Material beispielsweise Aluminium-Nitrid (AlN) und/oder Aluminium-Oxid (Al₂O₃) aufweisen oder aus solchen Verbindungen sein.
Gemäß einer weiteren Ausführungsform können für die Zwischenschicht zumindest ein Fotolack, ein Lötstopplack oder ein Metall verwendet werden, wobei das Metall ausgewählt sein kann aus zumindest einem aus Kupfer, Gold, Silber, Wolfram, Molybdän und Nickel sowie Legierungen und Mischungen und Schichtenfolgen daraus. Derartige Metalle können eine geringere Härte als die Trägerschicht aufweisen und damit weicher als die Trägerschicht sein. Derartige Materialien ermöglichen es weiterhin gleichermaßen, dass die Zwischenschicht nicht nur mit dem ersten Sägeblatt durchtrennt werden kann, das für das Durchtrennen der Vergussschicht mit der vergleichsweise geringsten Härte optimiert ist, sondern auch mit dem zweiten Sägeblatt, das für das Durchtrennen der Trägerschicht mit der vergleichsweise größten Härte geeignet ist.

Gemäß einer weiteren Ausführungsform kann die Vergussschicht Silikon umfassen, das beispielsweise ausgewählt ist aus Methyl-basiertem, Phenyl-basiertem und/oder fluoriertem Silikon. Weiterhin sind auch Gemische mit Silikon in veränderlichen prozentualen Anteilen wie beispielsweise Silikon und Epoxidharzen denkbar. Alternativ können auch Gemische aus Methyl-basiertem, Phenyl-basiertem oder fluoriertem Silikon verwendet werden. Dabei können sich Silikone dadurch auszeichnen, dass sie besonders undurchlässig gegenüber Luft und insbesondere Sauerstoff sowie gegenüber Feuchtigkeit sind und darüber hinaus UVbeständig sind. Des Weiteren sind Silikone dadurch gekennzeichnet, dass sie einen Betrieb strahlungsemittierender Bauelemente bei hohen Temperaturen ermöglichen, beispielsweise bis über 150°C. Ein Verguss mit Silikonen ermöglicht zudem die Formung eines optischen Elementes aus der Vergussschicht, wie beispielsweise einer Linse, die als Teil der Vergussschicht bevorzugt direkt oberhalb der strahlungsemittierenden Vorrichtung im strahlungsemittierenden Bauelement angeordnet sein kann.

Bevorzugt werden in der Vergussschicht Methyl-basierte Silikone mit einer Shore-Härte von Shore A60 bis Shore A90 verwendet, besonders bevorzugt werden Methyl-basierte Silikone mit einer Shore-Härte von Shore A70 bis Shore A80 verwendet, die über eine hohe Materialstabilität verfügen.

Technische Analysen von mittels des hier beschriebenen Verfahrens hergestellten strahlungsemittierenden Bauelementen ergaben, dass das Silikon einer Silikon-haltigen Vergussschicht weitaus besser auf der Zwischenschicht haftet, wenn die Zwischenschicht erfindungsgemäß Lötstopplack oder Photolack aufweist, als wenn die Zwischenschicht ein Metall umfasst. Die verbesserte Haftung der Vergussschicht an der Zwischenschicht kann dazu beitragen, die Verschmutzung der Sägekanten der Trennbereiche durch Reste der Vergussschicht zu reduzieren.

Gemäß einer weiteren Ausführungsform weisen zumindest die Trennbereiche der Trägerschicht eine Welligkeit auf, die durch das Aufbringen der Zwischenschicht im Verfahrensschritt B) planarisiert wird. Die Welligkeit der Trägerschicht kann beispielsweise durch ein Tastverfahren, ein Staudruckverfahren, oder durch ein optisches Verfahren ermittelt werden. Bevorzugt kann die Welligkeit der Trägerschicht an 5 bis 10 Punkten der Trägerschicht durch ein Tastverfahren ermittelt werden.

Im Zuge des Aufbringens der Zwischenschicht auf die Trägerschicht im Verfahrensschritt B) kann zunächst Material der Zwischenschicht, das beispielsweise flüssig sein kann, in die Unebenheiten eindringen und die Welligkeit beseitigen. Insbesondere kann die Zwischenschicht bevorzugt mit einer Schichtdicke aufgebracht werden, die größer oder zumindest gleich der größtmöglichen Welligkeit der Trägerschicht ist. Damit kann eine Beschädigung des ersten Sägeblattes durch das Auftreffen auf die maximalen Welligkeitsspitzen als der größtmöglichen Welligkeit der Trägerschicht mithilfe der als Schutz- oder Pufferschicht aufgebrachten Zwischenschicht weitgehend vermieden werden. Je nach dem für die Trägerschicht verwendeten Material sind Welligkeiten von 5 bis 50 µm möglich, sodass eine Zwischenschicht mit einer Schichtdicke aufgebracht wird, die um 5 bis 50 µm und bevorzugt um 5 bis 20 µm über die maximalen Welligkeitsspitzen der Welligkeit der Trägerschicht hinausragt. Dabei kann die Aufbringung der Zwischenschicht photochemisch erfolgen.

Zur Ermittlung der Welligkeit der Trägerschicht mit den bereits oben erwähnten Verfahren kann die Trägerschicht gemäß einer weiteren Ausführungsform im Verfahrensschritt A) auf einer Folie angeordnet bereitgestellt werden. Dazu kann die Trägerschicht auf die Folie geklebt und dabei beispielsweise laminiert werden. Die Folie kann auf vorteilhafte Weise ermöglichen, dass die Trägerschicht auf einer nahezu völlig ebenen Fläche aufliegt und Materialien wie etwa Polyvinylchlorid (PVC), Polyethylenterephthalat (PET), Polyethylen (PE) oder Polyolefin (PO) aufweisen. Die Zwischenschicht, die Mehrzahl der strahlungsemittierenden Vorrichtungen und der Vergussschicht können anschließend in den Verfahrensschritten B), C) und D) auf einer der Folie gegenüber liegenden Oberfläche der Trägerschicht durchgeführt werden.

Weiterhin kann die Folie im zweiten Trennschritt im Verfahrensschritt F) zumindest teilweise durchtrennt werden, was begünstigt, dass die geschaffene Ebene im weiteren Herstellungsverfahren erhalten bleiben kann.

Ein mit dem erfindungsgemäßen Verfahren herstellbares strahlungsemittierendes Bauelement umfasst
- eine Trägerschicht mit einem Montagebereich,
- eine strahlungsemittierende Vorrichtung angeordnet im Montagebereich, und
- eine Vergussschicht auf der strahlungsemittierenden Vorrichtung,
wobei benachbart zum Montagebereich zwischen der Trägerschicht und der Vergussschicht eine Zwischenschicht angeordnet ist.

Dass die Vergussschicht "auf" der strahlungsemittierenden Vorrichtung angeordnet oder aufgebracht ist, kann dabei hier und im Folgenden bedeuten, dass die Vergussschicht unmittelbar in direktem mechanischen Kontakt auf der strahlungsemittierenden Vorrichtung angeordnet oder aufgebracht ist. Weiterhin kann auch ein mittelbarer Kontakt bezeichnet sein, bei dem weitere Schichten zwischen der Vergussschicht und der strahlungsemittierenden Vorrichtung angeordnet sind.

Eine "benachbarte" Anordnung der Zwischenschicht zum Montagebereich zwischen der Trägerschicht und der Vergussschicht kann hier und im Folgenden bedeuten, dass die Zwischenschicht in direktem Kontakt zum Montagebereich angeordnet sein kann, sodass die Zwischenschicht und der Montagebereich unmittelbar aneinander angrenzen. Weiterhin kann auch ein mittelbarer Kontakt bezeichnet sein, bei dem weitere Schichten oder Bereiche zwischen dem Montagebereich und der Zwischenschicht angeordnet sind.

Ein derartiges strahlungsemittierendes Bauelement kann als Halbleiterbauelement, bevorzugt als Leuchtdiodenchip oder als Laserdiodenchip ausgeführt sein.

Des Weiteren kann ein derartiges strahlungsemittierendes Bauelement auf Oberflächen, wie beispielsweise Leiterplatten, mittels einer Oberflächenmontagetechnik montiert werden. Dadurch ist eine sehr dichte Bestückung, vor allem eine beidseitige Bestückung der Leiterplatte möglich.

Ein derartiges strahlungsemittierendes Bauelement kann darüber hinaus den JEDEC-1 Standard erreichen, was bedeuten kann, dass ein derartiges strahlungsemittierendes Bauelement zum Schutz vor eindringender Feuchtigkeit und Oxidationsschäden nicht in einem so genannten "Dry-Pack" verpackt und gelagert werden muss, sondern in der Umgebung des Herstellungsverfahrens gelagert werden kann. Dadurch kann die Anreicherung von Feuchtigkeit im strahlungsemittierenden Bauelement weitgehend vermieden werden, sodass das Verlöten der beispielsweise auf Leiterbahnen angeordneten strahlungsemittierenden Bauelemente im Reflow-Verfahren nicht zu Rissen im strahlungsemittierenden Bauelement und zur Delaminierung der Schichten des strahlungsemittierenden Bauelements führt (so genannter "Popcorning-Effekt").

Gemäß einer weiteren Ausführungsform kann die Zwischenschicht den Montagebereich umgeben. Das kann bedeuten, dass der Montagebereich an zumindest zwei Oberflächen durch die Zwischenschicht begrenzt wird. Weiterhin kann das bedeuten, dass die im Montagebereich angeordnete strahlungsemittierende Vorrichtung an zumindest zwei Oberflächen von der Zwischenschicht umgeben wird. Der Bereich, in dem die Zwischenschicht die strahlungsemittierende Vorrichtung umgibt, kann auch als Trennbereich bezeichnet werden.

Gemäß einer weiteren Ausführungsform können zumindest im Montagebereich der Trägerschicht zumindest eine elektrische Kontaktschicht aufgebracht werden. Dabei dient die zumindest eine elektrische Kontaktschicht der elektrischen Ankontaktierung der strahlungsemittierenden Vorrichtung von unten und kann als untere Elektrode, beispielsweise als Leiterbahn ausgeformt sein. Zur Gegenkontaktierung kann die strahlungsemittierende Vorrichtung mit einer oberen Elektrode versehen werden, die beispielsweise einen Bonddraht umfassen kann.

Weitere Vorteile, bevorzugte Ausführungsformen und Weiterbildungen des Verfahrens zur Herstellung einer Mehrzahl von strahlungsemittierenden Bauelementen sowie des strahlungsemittierenden Bauelements ergeben sich aus den im Folgenden und in Verbindung mit den Figuren erläuterten Ausführungsbeispielen.

Es zeigen:
Figuren 1A bis 1F schematische Schnittdarstellungen von Verfahrensschritten eines Verfahrens gemäß einem Ausführungsbeispiel, und
Figuren 2A und 2B einzelne Verfahrensschritte eines Verfahrens gemäß einem weiteren Ausführungsbeispiel.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

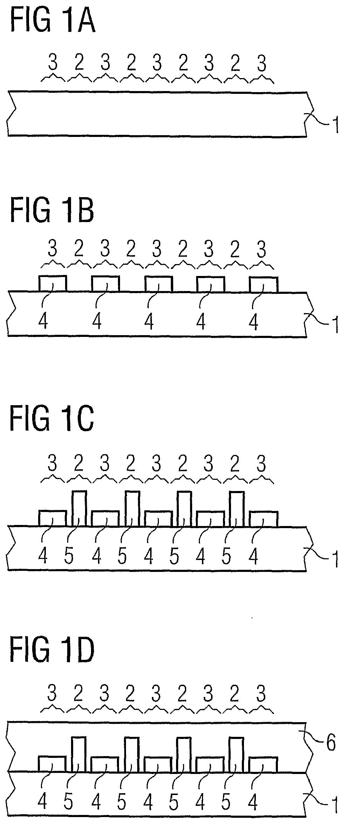

In den Figuren 1A bis 1F sind Verfahrensschritte eines Verfahrens gemäß einem Ausführungsbeispiel dargestellt. Figur 1A zeigt eine schematische Schnittdarstellung eines Verfahrensschrittes A), bei dem eine Trägerschicht 1 bereitgestellt wird, die eine Mehrzahl von Montagebereichen 2 aufweist. Dabei sind die Montagebereiche 2 durch Trennbereiche 3 voneinander getrennt. Die Trennbereiche 3 und die Montagebereiche 2 können beispielsweise in voneinander getrennten Spalten und Zeilen angeordnet sein. Bevorzugt sind die Montagebereiche 2 mit dazwischen angeordneten Trennbereichen 3 in Spalten und Zeilen in einer Matrixform auf der Trägerschicht 1 flächig angeordnet. Als Material für die Trägerschicht 1 werden bevorzugt ein Keramik-Material, ein Halbleitermaterial wie beispielsweise Silizium oder Metalle, die beispielsweise auch auf der Oberfläche oxidiert sein können oder ein Kunststoff-Material verwendet, da es sich durch eine große Härte und durch geringe Materialkosten auszeichnet. Dabei weist die Trägerschicht je nach dem, welches Material für die Trägerschicht verwendet wird, eine Welligkeit von 5 bis 50 µm auf.

Figur 1B zeigt eine schematische Schnittdarstellung eines weiteren Verfahrensschrittes B), bei dem auf die Trennbereiche 3 der Trägerschicht 1 eine Zwischenschicht 4 aufgebracht wird. Bevorzugt werden als Materialien der Zwischenschicht ein Photolack, ein Lötstopplack, oder ein Metall, wie beispielsweise Nickel, Kupfer, Silber, Wolfram, Molybdän oder Gold oder eine Mischung oder eine Legierung der Metalle in veränderlichen prozentualen Anteilen oder eine Schichtenfolge mit den genannten Materialien verwendet. Durch das Aufbringen der Zwischenschicht in den Trennbereichen der Trägerschicht wird die Welligkeit der Trägerschicht planarisiert. Insgesamt wird dabei eine Schichtdicke der Zwischenschicht 4 bevorzugt, die zumindest gleich, bevorzugt aber größer als die größtmögliche Welligkeit der Trägerschicht 1 in den Trennbereichen 3 ist. Die größtmögliche Welligkeit wurde dazu zuvor an 5 bis 10 Punkten auf der Oberfläche der Trägerschicht 1 in den Trennbereichen 3 beispielsweise durch ein Tastverfahren ermittelt.

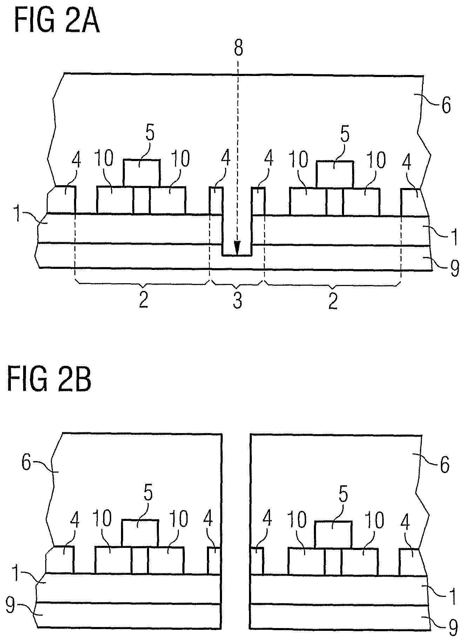

Figur 1C zeigt eine schematische Schnittdarstellung eines Verfahrensschrittes C), bei dem auf jeden der Mehrzahl der Montagebereiche 2 jeweils eine strahlungsemittierende Vorrichtung 5 aufgebracht wird. Dabei kann jede der strahlungsemittierenden Vorrichtungen 5 direkt an die benachbarten Trennbereiche 3 angrenzen oder auch wie hier dargestellt, beabstandet zu benachbarten Trennbereichen 3 im Montagebereich 2 auf der Trägerschicht 1 angeordnet sein. Zur elektrischen Anbindung der strahlungsemittierenden Vorrichtungen 5 ist es möglich, vor dem Verfahrensschritt C) zumindest in der Mehrzahl der Montagebereiche 2 jeweils zumindest eine elektrische Kontaktschicht 10, wie in den Figuren 2A und 2B dargestellt, aufzubringen. Dabei können das Material der elektrischen Kontaktschicht 10 und der Zwischenschicht 4 das gleiche Material aufweisen oder aus dem gleichen Material sein. In dem Fall ist es möglich, die elektrische Kontaktschicht 10 und die Zwischenschicht 4 in einem Verfahrensschritt strukturiert auf die Montagebereiche 2, beziehungsweise auf die Trennbereiche 3 aufzubringen.

Figur 1D zeigt eine schematische Schnittdarstellung eines Verfahrensschrittes D), bei dem auf die strahlungsemittierenden Vorrichtungen 5 und die Zwischenschicht 4 eine zusammenhängende Vergussschicht 6 großflächig aufgebracht wird. Die Vergussschicht 6 kann bevorzugt Methyl-basiertes oder Phenyl-basiertes Silikon enthalten, aus dem eine Linse geformt werden kann. Die Vergussschicht 6 wird daher bevorzugt so auf der strahlungsemittierenden Vorrichtung 5 angeordnet, sodass die Linse der Vergussschicht 6 direkt auf der strahlungsemittierenden Vorrichtung 5 aufliegt.

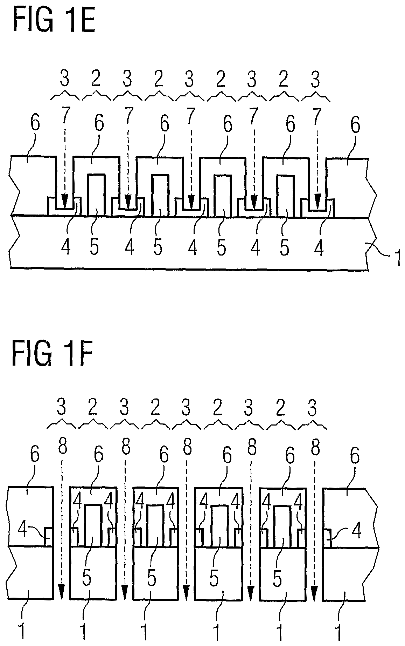

Figur 1E zeigt eine schematische Schnittdarstellung eines Verfahrensschrittes E), bei dem in einem ersten Trennschritt 7 die Vergussschicht 6 vollständig durchtrennt und die Zwischenschicht 4 partiell durchtrennt wird. Dabei wird der Verlauf des ersten Trennschnittes 7 durch gestrichelte Pfeile 7 dargestellt. Dadurch, dass in diesem ersten Trennschritt 7 eine vollständige Durchtrennung der Vergussschicht 6 erfolgt, können glatte Sägekanten ohne Überstände der Vergussschicht 6 entstehen.

Figur 1F zeigt eine schematische Schnittdarstellung eines Verfahrensschrittes F), bei dem in einem zweiten Trennschritt 8 (gestrichelte Pfeile) die Zwischenschicht 4 partiell und die Trägerschicht 1 vollständig durchtrennt werden. Dabei wird die Zwischenschicht 4 durch den ersten, in Figur 1E) dargestellten Trennschritt 7 und durch den zweiten, in Figur 1F) dargestellten Trennschritt 8 vollständig durchtrennt. Somit entstehen abschließend mit dem Verfahrensschritt F) eine Mehrzahl strahlungsemittierender Bauelemente, deren Trennung beispielsweise mit einer Säge möglich ist. Zur Trennung der strahlungsemittierenden Bauelemente können zwei verschiedene Sägeblätter eingesetzt werden, wobei das für den ersten Trennschritt 7 verwendete Sägeblatt dabei auf das vollständige Trennen der Vergussschicht 6 optimiert ist, während das zweite Sägeblatt für den zweiten Trennschritt 8 zur Trennung der Trägerschicht 1 geeignet ist. Die Zwischenschicht 4 weist dabei bevorzugt ein Material wie beispielsweise einen Photolack, einen Lötstopplack oder ein Material wie Kupfer, Nickel, Silber, Wolfram, Molybdän oder Gold, oder eine Mischung oder eine Legierung oder eine Schichtenfolge daraus auf, sodass die Zwischenschicht 4 nicht nur mit einem Sägeblatt durchtrennt werden kann, das für das Durchtrennen der Vergussschicht 6 mit der vergleichsweise geringsten Härte optimiert ist, sondern auch mit einem Sägeblatt, das für das Durchtrennen der Trägerschicht 1 mit der vergleichsweise größten Härte geeignet ist.

Somit liegt zum Abschluss des in der Figur 1F beschriebenen Verfahrensschrittes F) eine Mehrzahl strahlungsemittierender Bauelemente vor.

In den Figuren 2A und 2B sind einzelne Verfahrensschritte eines Verfahrens zur Herstellung strahlungsemittierender Bauelemente gemäß einem weiteren Ausführungsbeispiel gezeigt.

Dabei wird im Vergleich zum Ausführungsbeispiel des Verfahrens gemäß der Figuren 1A bis 1F die Trägerschicht 1 auf einer Folie 9 angeordnet bereitgestellt, um die in den Figuren 1E und 1F dargestellten Trennschritte 7 und 8 auf einer möglichst planen Fläche durchzuführen. Um die plane Fläche für weitere Verarbeitungsprozesse der strahlungsemittierenden Bauelemente zu erhalten, wird die Folie 9, wie in der Figur 2A in einer schematischen Schnittdarstellung dargestellt, während des zweiten Trennschrittes 8 gemäß dem Verfahrensschritt F) nur partiell durchtrennt. Die strahlungsemittierenden Vorrichtungen 5 sind auf elektrischen Kontaktschichten 10 angeordnet, wobei die elektrischen Kontaktschichten 10 in den Montagebereichen 2 vor dem Aufbringen der strahlungsemittierenden Vorrichtungen 5 im oben beschriebenen Verfahrensschritt C) auf die Trägerschicht 1 aufgebracht werden. Im gezeigten Ausführungsbeispiel sind die strahlungsemittierenden Vorrichtungen 5 dabei mittels eine Flip-Chip-Montage aufgebracht.

Die vollständige Trennung der bereits voneinander getrennten strahlungsemittierenden Bauelemente von der Folie 9 erfolgt abschließend an einer Trennkante in einem weiteren Verfahrensschritt, wodurch wie in Figur 2B gezeigt, eine Vereinzelung in die Mehrzahl strahlungsemittierender Bauelemente erreicht wird.

## Patentansprüche

1. Verfahren zur Herstellung einer Mehrzahl von strahlungsemittierenden Bauelementen, umfassend die Verfahrensschritte:
A) Bereitstellen einer Trägerschicht (1) mit einer Mehrzahl von Montagebereichen (2), wobei die Montagebereiche (2) durch Trennbereiche (3) voneinander getrennt sind,
B) Aufbringen einer Zwischenschicht (4) auf die Trennbereiche (3);
C) Aufbringen jeweils einer strahlungsemittierenden Vorrichtung (5) auf jeden der Mehrzahl der Montagebereiche (2) ;
D) Aufbringen einer zusammenhängenden Vergussschicht (6) auf die strahlungsemittierenden Vorrichtungen (5) und die Trennbereiche (3);
E) Durchtrennen der Vergussschicht (6) und partielles Durchtrennen der Zwischenschicht (4) in den Trennbereichen (3) der Trägerschicht (1) in einem ersten Trennschritt (7);
F) Partielles Durchtrennen der Zwischenschicht (4) und Durchtrennen der Trägerschicht (1) in einem zweiten Trennschritt (8), wobei die Zwischenschicht (4) durch den ersten (7) und den zweiten Trennschritt (8) vollständig durchtrennt wird.

2. Verfahren nach dem vorhergehenden Anspruch, wobei
- die Trennung im ersten Trennschritt (7) und im zweiten Trennschritt (8) jeweils mit einer Säge durchgeführt wird wobei die Trennung im ersten Trennschritt (7) insbesondere mit einem ersten Sägeblatt durchgeführt wird.

3. Verfahren nach dem vorhergehenden Anspruch, wobei
- die Trennung im zweiten Trennschritt (8) mit einem zweiten Sägeblatt durchgeführt wird, und
- das verschieden vom ersten Sägeblatt ist.

4. Verfahren nach Anspruch 3, wobei
- das erste Sägeblatt und das zweite Sägeblatt eine gleiche Dicke aufweisen.

5. Verfahren nach einem der vorhergehenden Ansprüche, wobei
- vor dem Verfahrensschritt C) zumindest in der Mehrzahl der Montagebereiche (2) der Trägerschicht (1) jeweils zumindest eine elektrische Kontaktschicht (10) aufgebracht wird.

6. Verfahren nach dem vorhergehenden Anspruch, wobei
- die Zwischenschicht (4) und die zumindest eine elektrische Kontaktschicht (10) ein gleiches Material aufweisen.

7. Verfahren nach dem vorhergehenden Anspruch, wobei
- die Zwischenschicht (4) und die elektrische Kontaktschicht (10) gleichzeitig im Verfahrensschritt B) aufgebracht werden.

8. Verfahren nach einem der vorhergehenden Ansprüche, wobei
- die Trägerschicht (1) eine erste Härte, die Zwischenschicht (4) eine zweite Härte und die Vergussschicht (6) eine dritte Härte aufweist,
- die erste Härte größer ist als die zweite Härte und
- die zweite Härte größer ist als die dritte Härte.

9. Verfahren nach einem der vorhergehenden Ansprüche, wobei
- die Trägerschicht (1) ein Keramik-Material umfasst.

10. Verfahren nach einem der vorhergehenden Ansprüche, wobei
- die Zwischenschicht (4) zumindest einen Photolack, einen Lötstopplack oder ein Metall umfasst,
- das ausgewählt ist aus zumindest einem aus Kupfer, Nickel, Silber, Wolfram, Molybdän und Gold oder aus einer Legierung oder aus einer Mischung oder aus einer Schichtenfolge davon.

11. Verfahren nach einem der vorhergehenden Ansprüche, wobei
- die Vergussschicht (6) Silikon umfasst,
- das ausgewählt ist aus Methyl-basiertem, Phenyl-basiertem, fluoriertem Silikon und/oder aus Gemischen, die ausgewählt sind aus
- Silikon und Epoxidharzen, oder
- Methyl-basiertem, Phenyl-basiertem und/oder fluoriertem Silikon.

12. Verfahren nach einem der vorhergehenden Ansprüche, wobei
- zumindest die Trennbereiche (3) der Trägerschicht (1) eine Welligkeit aufweisen,
- die durch das Aufbringen der Zwischenschicht (4) in Verfahrensschritt B) planarisiert wird- wobei die Zwischenschicht (4) insbesondere eine Schichtdicke aufweist, die größer oder gleich der Welligkeit der Trägerschicht (1) ist.

13. Verfahren nach einem der vorhergehenden Ansprüche, wobei
- die Trägerschicht (1) im Verfahrensschritt A) auf einer Folie (9) angeordnet bereitgestellt wird und
- das Aufbringen der Zwischenschicht (4), der Mehrzahl von strahlungsemittierenden Vorrichtungen (5) und der Vergussschicht (6) in den Verfahrensschritten B), C) und D) auf einer der Folie (9) gegenüber liegenden Oberfläche der Trägerschicht (1) durchgeführt wird.

## Claims

1. A method for producing a plurality of radiation-emitting components, comprising the method steps:
A) providing a carrier layer (1) having a plurality of mounting regions (2) wherein the mounting regions (2) are separated from one another by separating regions (3);
B) applying an intermediate layer (4) to the separating regions (3);
C) applying a radiation-emitting device (5) to each of the plurality of mounting areas (2);
D) applying a continuous casting layer (6) to the radiation-emitting devices (5) and the separating regions (3);
E) severing of the casting layer (6) and partial severing of the intermediate layer (4) in the separating regions (3) of the carrier layer (1) in a first separation step (7);
F) partial severing of the intermediate layer (4) and severing of the carrier layer (1) in a second separation step (8), wherein the intermediate layer (4) is completely severed by the first (7) and the second separating step (8).

2. The method according to the preceding claim, wherein
- the separation in the first separation step (7) and in the second separation step (8) is in each case done with a saw, wherein the separation in the first separation step (7) is carried out in particular with a first saw blade.

3. The method according to the preceding claim, wherein
- the separation in the second separation step (8) is carried out with a second saw blade, and
- which is different from the first saw blade.

4. The method according to claim 3, wherein
- the first saw blade and the second saw blade have the same thickness.

5. The method according to one of the preceding claims, wherein
- before the method step C) at least in the plurality of mounting areas (2) of the carrier layer (1) in each case at least one electrical contact layer (10) is applied.

6. The method according to the preceding claim, wherein
- the intermediate layer (4) and the at least one electrical contact layer (10) comprise the same material.

7. The method according to the preceding claim, wherein
- the intermediate layer (4) and the electrical contact layer (10) are applied simultaneously in the method step B).

8. The method according to one of the preceding claims, wherein
- the carrier layer (1) has a first hardness, the intermediate layer (4) has a second hardness and the casting layer (6) has a third hardness,
- the first hardness is greater than the second hardness, and
- the second hardness is greater than the third hardness.

9. The method according to one of the preceding claims, wherein
- the carrier layer (1) comprises a ceramic material.

10. The method according to one of the preceding claims, wherein
- the intermediate layer (4) comprises at least one of a photoresist, a solder resist and a metal,
- which is selected from at least one of copper, nickel, silver, tungsten, molybdenum and gold or of an alloy or of a mixture or of a layer sequence thereof.

11. The method according to one of the preceding claims, wherein
- the casting layer (6) comprises a silicone,
- which is selected from methyl-based, phenyl-based, fluorinated silicone and/or mixtures selected from
- silicone and epoxy resins, or
- methyl-based, phenyl-based and/or fluorinated silicone.

12. The method according to one of the preceding claims, wherein
- at least the separating regions (3) of the carrier layer (1) have a waviness,
- which is planarized by the application of the intermediate layer (4) in the method step B),
- wherein the intermediate layer (4) in particular has a layer thickness which is greater than or equal to the waviness of the carrier layer (1).

13. The method according to one of the preceding claims, wherein
- the carrier layer (1) is provided arranged on a film (9) in the method step A), and
- applying of the intermediate layer (4), of the plurality of radiation-emitting devices (5) and of the casting layer (6) in the method steps B), C) and D) is carried out on a surface of the carrier layer (1) opposite the foil (9).

## Revendications

1. Procédé de fabrication de plusieurs dispositifs émetteurs de rayonnement, comprenant les étapes suivantes :
A) mise à disposition d'une couche de support (1) présentant une pluralité de zones de montage (2), les zones de montage (2) étant séparées les unes des autres par des zones de séparation (3),
B) application d'une couche intermédiaire (4) sur les zones de séparation (3);
C) application d'un dispositif émetteur de rayonnement (5) sur chacune des zones de montage (2) ;
D) application d'une couche d'enrobage continue (6) sur les dispositifs émetteurs de rayonnement (5) et les zones de séparation (3);
E) sectionnement de la couche d'enrobage (6) et sectionnement partiel de la couche intermédiaire (4) dans les zones de séparation (3) de la couche de support (1) lors d'une première étape de séparation (7);
F) sectionnement partiel de la couche intermédiaire (4) et sectionnement de la couche de support (1) lors d'une deuxième étape de séparation (8), la couche intermédiaire (4) étant complètement sectionnée par la première (7) et la deuxième étape de séparation (8).

2. Procédé selon la revendication précédente, dans lequel
- la séparation est réalisée au moyen d'une scie lors de la première (7) et de la deuxième étape de séparation (8), la séparation se faisant en particulier avec une première lame de scie durant la première étape de séparation (7).

3. Procédé selon la revendication précédente, dans lequel
- la séparation est réalisée au moyen d'une deuxième lame de scie lors de la deuxième étape de séparation (8), et
- celle-ci étant différente de la première lame de scie.

4. Procédé selon la revendication 3, dans lequel
- la première lame de scie et la seconde lame de scie présentent une épaisseur égale.

5. Procédé selon l'une des revendications précédentes, dans lequel
- au moins une couche de contact électrique (10) est respectivement appliquée au moins dans la pluralité des zones de montage (2) de la couche support (1) avant l'étape C).

6. Procédé selon la revendication précédente, dans lequel
- la couche intermédiaire (4) et au moins une couche de contact électrique (10) présentent un matériau identique.

7. Procédé selon la revendication précédente, dans lequel la couche intermédiaire (4) et la couche de contact électrique (10) sont appliquées simultanément à l'étape B).

8. Procédé selon l'une des revendications précédentes, dans lequel
- la couche de support (1) présente une première dureté, la couche intermédiaire (4) une deuxième dureté et la couche d'enrobage (6) une troisième dureté,
- la première dureté est supérieure à la deuxième dureté et
- la deuxième dureté est supérieure à la troisième dureté.

9. Procédé selon l'une des revendications précédentes, dans lequel
- la couche de support (1) comprend un matériau céramique.

10. Procédé selon l'une des revendications précédentes, dans lequel
- la couche intermédiaire (4) comprend au moins une résine photosensible, une réserve de soudure ou un métal,
- qui est choisi au moins parmi l'un des métaux suivants : cuivre, nickel, argent, tungstène, molybdène et or ou un alliage ou un mélange ou une succession de couches de ceux-ci.

11. Procédé selon l'une des revendications précédentes, dans lequel
- la couche d'enrobage (6) comprend du silicone,
- choisi parmi du silicone fluoré à base de méthyle, de phényle et / ou de mélanges choisis parmi
- des résines de silicone et époxy ou
- du silicone à base de méthyle, de phényle et / ou fluoré.

12. Procédé selon l'une des revendications précédentes, dans lequel
- au moins les zones de séparation (3) de la couche de support (1) présentent une ondulation,
- qui est planarisée par l'application de la couche intermédiaire (4) à l'étape B) - la couche intermédiaire (4) présentant notamment une épaisseur de couche supérieure ou égale à l'ondulation de la couche de support (1).

13. Procédé selon l'une des revendications précédentes, dans lequel
- la couche de support (1) est fournie sur un film (9) à l'étape A) et
- la couche intermédiaire (4), la pluralité de dispositifs émetteurs de rayonnement (5) et la couche d'enrobage (6) sont appliquées aux étapes B), C) et D) sur une surface de la couche de support (1) opposée au film (9).
